# EUROPEAN PATENT SPECIFICATION

(11) **EP 2 180 534 B1**
(45) Date of publication and mention of the grant of the patent: **16.10.2013**
(21) Application number: 08305734.9
(22) Date of filing: 27.10.2008
(51) Int. Cl.: H01L 35/30, F01N 3/28, H01L 35/22, H01L 35/32

(54) **Energy conversion devices and methods**
Energieumwandlungsvorrichtungen und Verfahren
Dispositifs et procédés de conversion d'énergie

(43) Date of publication of application: 28.04.2010
(73) Proprietor: Corning Incorporated, Corning NY 14831 (US)
(72) Inventor: Dannoux, Thierry, 77210, Avon (FR); Marques, Paulo, 77300, Fontainebleau (FR)
(74) Representative: Le Roux, Martine

(56) References cited:
- EP-A- 0 880 184
- EP-A- 1 796 182
- EP-A- 1 965 446
- EP-A- 1 970 971
- JP-A- 4 085 973
- JP-A- 2003 348 867
- JP-A- 2006 034 046
- US-A1- 2005 172 993
- US-A1- 2005 217 714

## Description

### TECHNICAL FIELD

The present teachings are directed to utilizing thermoelectric devices to convert waste heat from a reaction process. In a more particular application, the present teachings are directed to a thermoelectric device that also is configured to perform catalytic conversion.

### BACKGROUND

The use of thermoelectric devices has been proposed as a way to increase the efficiency of power systems that rely on hydrocarbon fuels (for example, coal, gasoline, diesel fuel, etc.) as energy sources. Currently, approximately 75% of the energy obtained from the combustion of a fuel such as gasoline is wasted due to thermal and other losses, and only about 25% of the energy is utilized by the vehicle for either moving it or powering equipment and accessories, such as, for example, various electronic components. In the case of diesel fuel, about 34% of the energy is utilized.

The electrical power demand of vehicles continues to increase due to, for example, more and more electrical components and electronics being added to vehicles. A thermoelectric recovery system may enhance the efficiency of hydrocarbon-powered vehicles by utilizing a part of the presently wasted thermal energy for direct electrical power conversion and could save the mechanical energy of the vehicles that is now used, for example by an alternator. This may result in a net saving of the overall chemical energy supplied by combustion of the fuel.

In many power generation applications, for example automotive applications, high temperature gradients exist. Therefore, it may be desirable to utilize thermoelectric devices to convert wasted heat energy to electrical energy, which may reduce environmental CO₂, facilitate the ability to use lighter and less powerful engines due to decreased load on the engine to supply power, facilitate the use of smaller batteries since electrical power could be supplied from the thermoelectric module once the engine is started, and/or potentially eliminate or minimize the use of equipment such as an alternator.

The ideal maximum output power of a thermoelectric device is highly dependent upon the thermal gradient. Accordingly, it may be desirable to place the thermoelectric device in a place where the temperature of exhaust gases from a combustion reaction is relatively high, for example, close to the engine block in an automotive application.

US 2005/172993 A1 discloses a thermoelectric generator for an internal combustion engine and has thermoelectric generation elements arranged between a sleeve and a cooling portion to convert heat energy from the exhaust in the passage to electric energy. To reduce thermal stresses arising from the thermal gradient, the thermoelectric elements are arranged in a moveable manner between the sleeve and the cooling portions.

JP 2006 034046 A discloses an exhaust heat recovery apparatus for the internal combustion engine of a motor vehicle. The thermo-elements are formed from semiconductor element blocks formed from sintered thermoelectric materials. The thermoelectric apparatus is placed in the exhaust system between the manifold and the catalytic converter.

US 2005/217714 A1 discloses an exhaust heat recovery system arranged in an exhaust path of an internal combustion engine. The thermoelectric module has a cylindrical geometry and its operating temperature is adapted to high-temperature side ends and low-temperature side ends of the exhaust system.

Challenges may arise, however, in using some conventional thermoelectric devices in light of the configuration of those devices, including, for example, the materials from which such devices are made. For example, some conventional thermoelectric devices include materials that operate under relatively low thermal gradients, for example, less than about 100 °C. When operating under higher temperature gradients, such as, for example, those encountered in post-combustion processes, including those in automotive applications, such conventional thermoelectric devices may not be able to withstand the associated thermo-mechanical stresses. Further, materials exhibiting a relatively high coefficient of thermal expansion may result in differential expansion (dilatation) between the hot and cold sides of the thermoelectric device, thereby causing excessive strain on the thermoelectric elements in the device.

Toxicity presents another issue and may arise due to the use of materials from which some conventional thermoelectric devices are made, in particular for the materials from which thermoelectric p- and n-type elements are made. Particularly in consumer applications, such as, for example, automotive applications, the use of toxic materials may be undesirable.

When performing catalytic conversion on combustion exhaust gases, such as, for example, in automotive applications, it also is desirable to position the catalytic conversion system within the exhaust gas flow proximate or at a location where those gases are hottest. Such a location may be desirable due to the delay that is often required to warm up a post-combustion catalytic conversion system to a temperature where the catalytic conversion reaction becomes relatively efficient (referred to as the light-off time). Prior to light-off, cold start pollution may occur.

Since both catalytic conversion systems and thermoelectric devices derive benefits from being positioned at a location of the exhaust gas flow having very high temperatures, it may be desirable to provide a device that combines catalytic conversion with thermoelectric energy generation so that both processes can utilize the high temperature exhaust gases.

In conventional catalytic conversion systems, heat from the catalytic conversion reaction, which is an exothermic reaction, is typically not collected or converted and is thus wasted. Therefore, it may further be desirable to utilize the wasted heat from an exothermic catalytic conversion reaction by converting that heat into another form of energy, such as, for example electric energy.

Moreover, it may be desirable to provide a thermoelectric device that is configured to and made of materials capable of withstanding relatively high temperature gradients and/or that does not pose toxicity issues.

### SUMMARY

Additional objects and desirable features will be set forth in part in the description which follows, and in part will be obvious from the description, or may be learned by practice of the present teachings. At least some of he objects and advantages of the present teachings may be realized and attained by means of the elements and combinations particularly pointed out in the appended claims.

It is to be understood that both the foregoing general description and the following detailed description are exemplary and explanatory only and are not restrictive of the present teachings or claims.

In accordance with various exemplary embodiments, the present teachings contemplate an energy conversion device comprising at least one hot source chamber configured to receive a hot fluid, wherein the at least one hot source chamber is configured to perform catalytic conversion of the fluid received therein, at least one cold source chamber configured to receive a coolant, and a plurality of thermoelectric elements in thermal communication with the at least one hot source chamber and the at least one cold source chamber, the thermoelectric elements being configured to create an electric potential when exposed to a temperature gradient, and the at least one hot source chamber and the at least one cold source chamber being formed from a material have a relatively low coefficient of thermal expansion of less than 30 x 10⁻⁷ °C⁻¹ at temperatures ranging from 20°C to 1000°C.

In various exemplary embodiments, the present teachings also contemplate a method for converting heat to electrical energy. The method may include flowing a hot fluid through at least one hot source chamber formed from a material having a relatively low coefficient of thermal expansion of less than 30 x 10⁻⁷ °C⁻¹ at temperatures ranging from 20°C to 1000°C, performing catalytic conversion of the fluid flowing through the hot source chamber, flowing a coolant through at least one cold source chamber formed from a material having a relatively low coefficient of thermal expansion of less than 30 x 10⁻⁷ °C⁻¹ at temperatures ranging from 20°C to 1000°C, and creating a temperature gradient across a plurality of thermoelectric elements via thermal exchange between the plurality of thermoelectric elements and the at least one hot source and at least one cold source chambers. The method also includes generating an electric potential via the plurality of thermoelectric elements.

### BRIEF DESCRIPTION OF DRAWINGS

The present teachings can be understood from the following detailed description either alone or together with the accompanying drawings. The drawings are included to provide a further understanding of the present teachings, and are incorporated in and constitute a part of this specification. The drawings illustrate one or more exemplary embodiments of the present teachings and, together with the description, serve to explain certain principles and operations. In the drawings,

FIG. 1 is a perspective view of an exemplary embodiment of an automotive vehicle engine block with exhaust pipes from each cylinder in flow communication with a respective thermoelectric generation and catalytic conversion devices in accordance with the present teachings;

FIG. 2 is a cross-sectional view of one of the thermoelectric generation and catalytic conversion devices of FIG. 1;

FIG. 3 is cross-sectional view of another exemplary embodiment of a thermoelectric generation and catalytic conversion device in accordance with the present teachings;

FIG. 4 is a partial cross-sectional view of an exemplary embodiment of the hot source chambers of the thermoelectric generation and catalytic conversion device of FIG. 2;

FIG. 5 is a cross-sectional view of the engine block, exhaust pipes and thermoelectric generation and catalytic conversion devices of FIG. 1;

FIG. 6 is a side view of an exemplary embodiment of fins on an inner surface portion of a hot source chamber of FIG. 2; and

FIG. 7 is a cross-sectional view of an exemplary embodiment of thermoelectric elements and electrodes that may be used in accordance with the present teachings.

Although the following detailed description makes reference to illustrative embodiments, many alternatives, modifications, and variations thereof will be apparent to those skilled in the art. Accordingly, it is intended that the claimed subject matter be viewed broadly.

### DETAILED DESCRIPTION OF EXEMPLARY EMBODIMENTS

Reference will now be made in detail to various exemplary embodiments, examples of which are illustrated in the accompanying drawings. The various exemplary embodiments are not intended to limit the disclosure. To the contrary, the disclosure is intended to cover alternatives, modifications, and equivalents.

The present teachings contemplate devices and methods that integrate catalytic conversion and thermoelectric energy generation. More specifically, the present teachings provide for utilizing a hot source chamber of a thermoelectric device as a catalytic conversion chamber. In this manner, both the exothermic catalytic conversion reaction heat energy and the post-combustion heat energy can be used for thermoelectric energy generation. The device may be placed at a position in a combustion system proximate to a location at which exhaust gases have a very high temperature, thus presenting a relatively high temperature gradient environment for operating the thermoelectric device. In automotive applications, for example, in various exemplary embodiments, the combined thermoelectric energy generation and catalytic conversion device may be positioned just outside of the cylinder block, substantially at the highest temperature exhaust gas location. Such positioning may provide a maximum thermal gradient, and thus a large thermoelectric power generation from both exhaust gas and exothermic catalytic conversion reaction.

The present teachings further contemplate utilizing materials having a relatively low coefficient of thermal expansion (CTE) to form the substrates that define the chambers that circulate the hot and cold fluids. For example, the present teachings contemplate using a monolithic glass ceramic structure for the hot and cold source chambers. Such configurations may better withstand a high temperature environment, including high temperature gradients, while also providing a relatively quick and efficient catalytic light-off effect. Regarding the former, materials having a relatively low CTE, such as, for example, various glass ceramic materials, can enable the thermoelectric energy generation and catalytic conversion device to withstand relatively high thermo-mechanical stresses without failure by minimizing differential expansion effects between the hot side and the cold side of the thermoelectric device. Regarding the latter, such materials that also exhibit a relatively large heat capacity may enable increased catalytic reactions and faster light-off times. The exothermic catalyzed post-combustion energy is used for enhanced thermoelectric energy generation.

Suitable materials exhibiting desirable CTEs that may be used to make the thermoelectric generation and catalytic conversion devices in accordance with exemplary embodiments of the present teachings are disclosed in international patent application publication WO 2008/106099, which published September 4, 2008, and is entitled "GLASS-CERAMIC THERMOELECTRIC MODULE," . WO 2008/106099, also discloses various methods for making a thermoelectric device for use in post-combustion applications and such manufacturing methods also may be used to form the thermoelectric energy generation and catalytic conversion devices of the present teachings, with modifications as appropriate and as would be obvious to those ordinarily skilled in the art.

In addition to the various aspects discussed above, in various exemplary embodiments according to the present teachings, the combined thermoelectric energy generation and catalytic conversion device configurations also may promote interaction of gases with catalytic sites, minimize space requirements, promote the ability to withstand vibrations, and/or eliminate the need for canning associated with some conventional catalytic conversion systems.

Although the exemplary embodiments of thermoelectric energy generation and catalytic conversion devices described below with reference to the drawings are discussed with reference to automotive vehicle applications, those having skill in the art would understand that the exemplary embodiments may be useful in a variety of applications, such as, for example, stationary power plant and combustion systems, in which it may be desirable to convert waste heat to usable electric energy and/or perform catalytic conversion on various waste fluid streams.

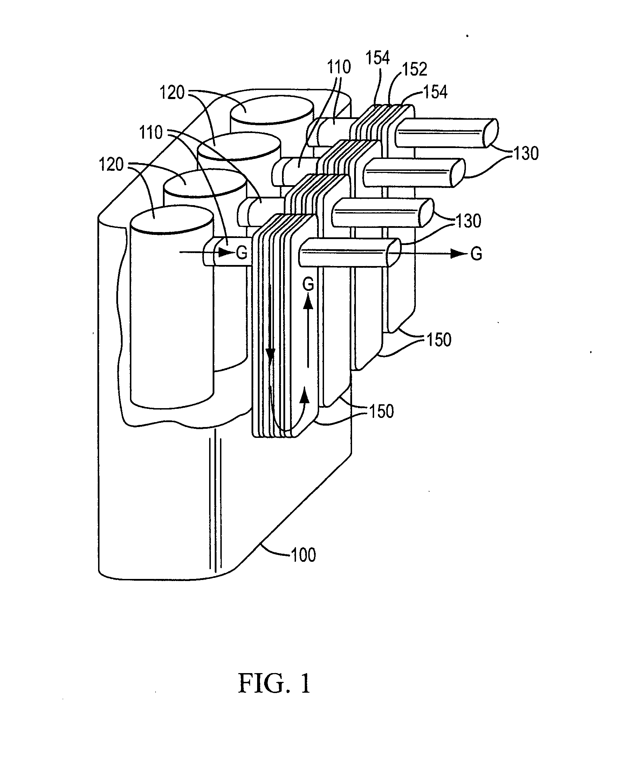

With reference now to FIG. 1, a perspective and schematic view of an exemplary embodiment of a cylinder block 100 of a four-cylinder internal combustion engine is depicted with exhaust pipes 110 leading from each cylinder 120 to a respective integrated thermoelectric energy generation and catalytic conversion device 150 in accordance with various exemplary embodiments of the present teachings. Post-combustion exhaust gases G from each cylinder 120 flow from the upstream exhaust pipes 110 through each of the thermoelectric energy generation and catalytic conversion devices 150 and exit out of downstream exhaust pipes 130, as shown by the arrows schematically representing the exhaust gas flow in FIG. 1.

As shown in the perspective view of FIG. 1, the integrated thermoelectric energy generation and catalytic conversion devices 150 may have a substantially planar, layered substrate configuration, with central substrate layers forming a hot source chamber (e.g., configured to receive the hot exhaust gases from the cylinders 120) and the outer substrate layers forming cold source chambers (e.g., configured to receive a coolant), as will be described in more detail below. As also will be described in further detail below, disposed between and in thermal contact with the hot source chamber and each of the cold source chambers is a thermoelectric element layer which includes a plurality of thermoelectric elements. Further details on exemplary methods for making the substrate layers and thermoelectric energy generation and catalytic conversion devices of the present teachings also are discussed below.

Those having skill in the art would appreciate that the four-cylinder internal combustion engine illustrated in FIG. 1 is exemplary only and engines having any number of cylinders may be utilized with the appropriate number of integrated thermoelectric/catalytic conversion devices, as desired. Moreover, in an exemplary embodiment, due to the materials disclosed herein for forming the thermoelectric energy generation and catalytic conversion device, it may be possible to utilize a single thermoelectric device spanning across all of the cylinders of the engine and that would be able to withstand associated thermo-mechanical stresses.

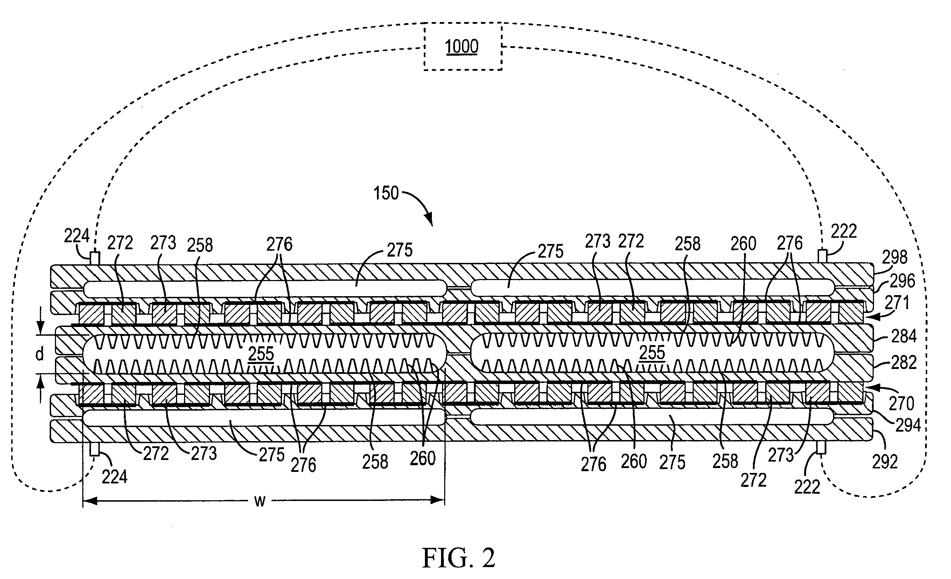

FIG. 2 depicts a cross-sectional view of an exemplary embodiment of an integrated thermoelectric energy generation and catalytic conversion device 150 in accordance with the present teachings. The cross-sectional view shown in FIG. 2 represents, for example, a cross-section taken in a plane of the device 150 lying substantially perpendicular to the longitudinal axis of the devices 150 illustrated in FIG. 1 (i.e., a plane parallel to the short sides of the devices 150).

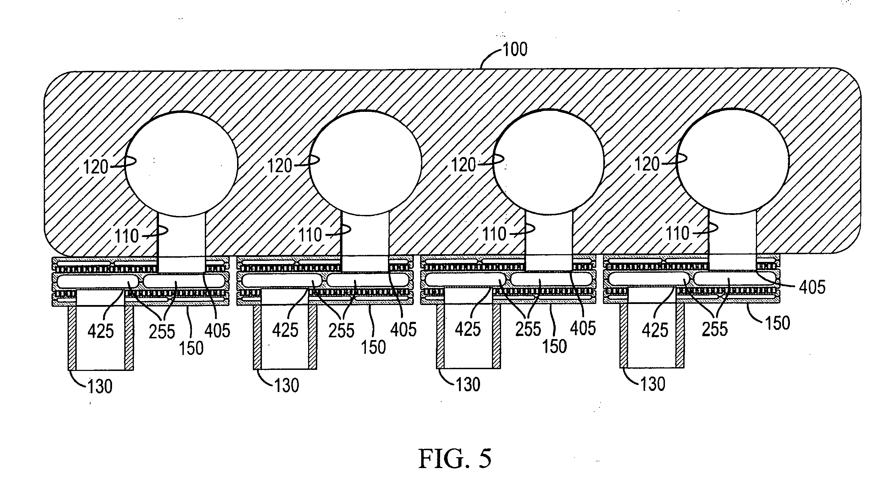

As shown in FIG. 2, the thermoelectric energy generation and catalytic conversion device 150 includes a plurality, here two, hot source chambers 255 that are in flow communication with hot exhaust gas from the engine (e.g., via an exhaust pipe such as exhaust pipe 110 depicted in FIGS. 1 and 5). The hot source chambers 255 also function as catalytic conversion chambers by incorporating a catalyst on inner surface portions of the chambers 255, as will be described in further detail below. In various exemplary embodiments, as shown in FIG. 2, the hot source chambers 255 may have a cross-sectional area substantially the same as that of conventional exhaust pipes, but in a flatter aspect ratio. Such a flatter aspect ratio may result in maximizing thermal exchange and/or interactions with the catalytic inner surface portions of the chambers 255. By way of non-limiting example, the hot source chambers 255 may have a depth d of about 5 mm to about 20 mm, for example, about 14 mm, and a width w of about 30 mm to about 60 mm, for example, about 45 mm.

External to and on opposite sides of the hot source chambers 255, is a layer 270, 271 of thermoelectric elements 272, 273. The layers 270, 271 of thermoelectric elements 272, 273 may be disposed substantially symmetrically on opposite sides of the substrates 282 and 284 that define the hot source chambers 255, thereby positioning the hot source chambers 255 substantially centrally of the overall device 150. By way of example, the thermoelectric elements may include p- and n-type thermoelectric elements 272, 273, respectively. Electrodes 276 may be in electrical contact with adjacent elements 272, 273. On a side of each thermoelectric element layer 270, 271 opposite the hot source chambers 255 are cold source chambers 275 that are configured to receive a cooling fluid. For example, in various exemplary embodiments, the chambers 275 may receive coolant via inlet and outlet ports 222, 224 from, for example, the automotive vehicle's cooling system (shown schematically as 1000 in FIG. 2)..

Thus, the thermoelectric elements 272, 273 are in thermal exchange with the hot source chambers 255 as a heat source on one side and with the cold source chambers 275 as a cooling source on the opposite side. Accordingly, as those with ordinary skill in the art are familiar, the temperature gradient across the thermoelectric elements 272, 273 from the hot source chambers 255 to the cold source chambers 275, may cause the thermoelectric elements 272, 273 to generate an electric potential and, with the electrodes 276, generate electricity. Electrical leads (not shown) may be placed in electrical contact with the electrodes 276 to conduct electricity generated from the device 250, for example, to an electrical storage device and/or directly to electronic and other components that can run off the generated electricity.

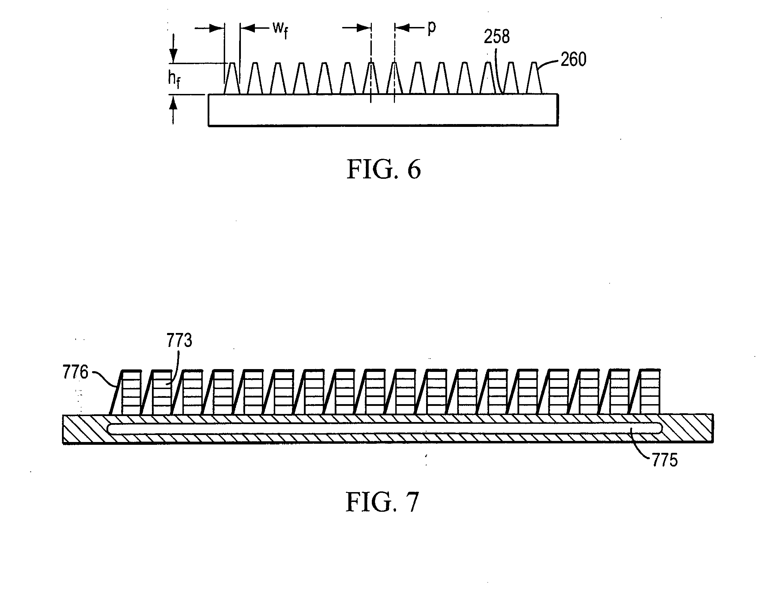

In an alternative embodiment, an example of which is shown in FIG. 7, in lieu of using the p- and n-type thermoelectric elements with electrodes connecting those elements provided on both sides of the elements, as depicted in FIG. 2 for example, the thermoelectric elements 773 may include a series of either p-type or n-type elements with S-shaped electrodes 776 used to connect the cold-side of one thermoelectric element to the hot-side of an adjacent thermoelectric element. The thermoelectric elements 773 may be linked together on only one side, the hot side or the cold side. In the exemplary embodiment, the linkage of the thermoelectric elements 773 is at the cold source chamber 775. Such a configuration may reduce the risks of excessive strain exerted on the thermoelectric elements 773 associated with differential dilatation of the hot and cold sides by, for example, permitting end regions of the thermoelectric elements 773 opposite the cold source chamber 775 in FIG. 7 to move relative to one another. Such a configuration for the thermoelectric elements and electrodes is described in more detail in international patent application publication WO 2007/065954 A1, which published on June 14, 2007, and is entitled "THERMOELECTRIC DEVICE,".

In various exemplary embodiments, coolant from the automotive vehicle cooling circuit may flow through the cold source chambers 275, and the coolant may have a temperature ranging from about 65 °C to about 70 °C. Such a temperature range may be desirable for thermoelectric element materials working at fairly high temperatures, for example, ranging from about 350 °C to about 850 °C. For example, for various exemplary thermoelectric element materials described herein, although the temperatures associated with the hot side of the temperature gradient are typically higher than in some conventional thermoelectric device applications, the temperatures of the cool side need not be as low as in those conventional applications. The ability to use higher cool side temperatures may be beneficial in power generation applications, such as, an automotive application for example, by eliminating the need to utilize a radiator or other equipment to cool the coolant to the appropriate temperature. Using thermoelectric materials having a relatively high dimensionless figure of merit ZT at higher operating temperatures may permit the use of such higher coolant temperatures.

In various exemplary embodiments, as depicted in FIG. 1, for example, hot exhaust gas may enter the thermoelectric energy generation and catalytic conversion device in one of the chambers 255, circulate through the device in a substantially U-shaped pathway, and exit from the other chamber 255. Accordingly, the gas may flow in substantially opposite directions in each of the chambers 255, as will be described in further detail below. Such a U-shaped flow pattern is exemplary, however, and those skilled in the art would appreciate that a variety of flow paths may be utilized within either the hot or cold source chambers of the thermoelectric generation and catalytic conversion devices of the present teachings. Such flow paths may be created by providing various structures, including but not limited to baffles, walls, valves, diaphragms, etc., within the chambers to control the flow of fluid therethrough. For example, flow in the hot source chambers may be in the same direction, and exhaust from each cylinder in the engine may be split and diverted into each of the hot source chambers of a thermoelectric energy generation and catalytic conversion device. In such a case, flow from each chamber may be combined to exit the device out of a single exhaust pipe.

Those ordinarily skilled in the art also will appreciate that any number of hot source chambers may be provided ranging from one to more than one, with each hot source chamber being sandwiched between two cooling source chambers. In an alternative exemplary embodiment, shown and described, for example, in WO 2008/106099, the one or more cooling source chambers may be disposed on only one side of the one or more hot source chambers, however, such a configuration could result in some reduction in efficiency.

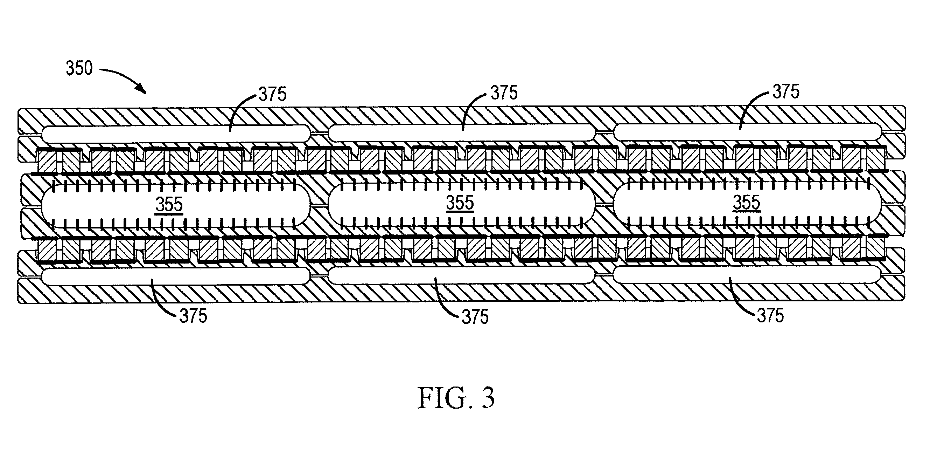

With reference to FIG. 3, for example, an exemplary embodiment of a thermoelectric energy generation and catalytic conversion device 350 is shown that includes three hot source chambers 355 each having two corresponding cooling source chambers 375 on either side thereof, thereby disposing the hot source chambers 355 substantially centrally. Hot fluid may circulate through each of the chambers 355 in the same direction or in differing directions (e.g., the direction of flow may be the same direction in two of the chambers 375, which differs from the direction of flow in the third chamber 375).

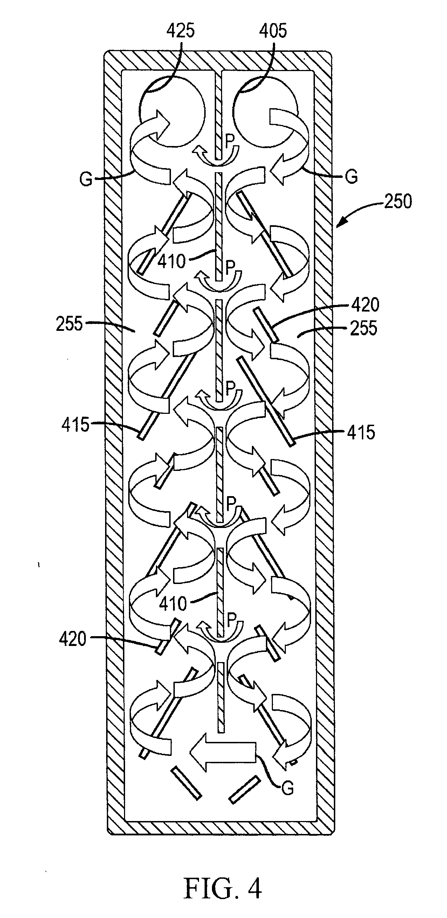

An exemplary embodiment of the use of baffles and inclined walls to alter the fluid flow path of the exhaust gas circulating through the central hot source chambers 255 is shown in the partial cross-sectional view of the thermoelectric energy generation and catalytic conversion device 250 in FIG. 4. The cross-section shown in FIG. 4 shows only the hot source chambers 255 and is taken in a plane substantially parallel to the longitudinal axis of the thermoelectric energy generation and catalytic conversion device 250. As depicted by the arrows in FIG. 4, exhaust gas G may enter into one of the central hot source chambers 255 through an inlet opening 405 that connects in flow communication with an exhaust pipe (not shown in FIG. 4) leading from one or more cylinders of the vehicle engine. In the exemplary embodiment of FIG. 4, a series of baffles 410 may separate the two chambers 255 from one another. The baffles 410 may be positioned such that most of the exhaust gas G flowing around a series of inclined walls 415 and 420 in each chamber 455 impinges upon the baffles 410. However, the spacing between consecutive baffles 410 may permit a portion P of the exhaust gas to bypass flowing through the entire lengths of the chambers 255 and flow directly from one chamber 255 to the other.

Alternatively, instead of the chambers 255 being separated by a series of spaced apart baffles, a single wall may be provided that extends substantially the entire length of the chambers 255. The length and positioning of such a wall may be such that gas can flow from one chamber to the next proximate an end of the chambers 255 opposite to the inlet and outlet openings 405 and 425, for example, in the manner shown by the main gas flow G in FIG. 4.

As mentioned above, each hot source chamber 255 may be provided with a series of inclined walls to cause the flow of gas G through each chamber 255 to have a tortuous path. In the exemplary embodiment of FIG. 4, for example, each chamber 255 is provided with an alternating arrangement of inclined walls 415 of longer length and inclined walls 420 of shorter length. In accordance with various exemplary embodiments, the walls 415 and 420 may be inclined at approximately 45°, although other angles of inclination are considered within the scope of the present teachings and may be selected to achieve desired mixing and/or gas flow patterns. Together, the inclined walls 415, 420 and the baffles 410 (or single wall) separating the chambers 255 may be configured to cause the gas G to flow from one chamber 255 to the other in a generally U-shaped flow path, while achieving a tortuous flow path within each chamber 255, as depicted in FIG. 4.

The tortuous flow path and bypass portion P of the gas G may create a turbulent flow that enhances molecule interactions and uniform temperature within the central chambers 255. Such effects may enhance both heat transfer, by providing a more uniform heat transfer to the thermoelectric elements, and catalytic conversion reactions. As discussed below in further detail, the chambers 255, in addition to being provided with baffles and/or inclined walls 415, 420, may be provided with fins (not shown in FIGS. 4 or 5 for simplification purposes) that are configured to promote heat transfer and/or catalytic conversion by, for example, increasing the heat transfer and catalytic surface area within the hot source chambers 255. In the embodiment of FIG. 4, such fins may be provided on either or both sides of the baffles 410 and/or along the inner surface wall portions defining the chambers 255.

Referring now to FIG. 5, a cross-section of an exemplary embodiment of the four-cylinder engine block 100 of FIG. 1 is shown with the thermoelectric energy generation and catalytic conversion devices 150 corresponding to each cylinder 120 of the engine block 100. The cross-section shown in FIG. 5 is taken in a plane lying substantially perpendicular to a longitudinal axis of the cylinders 120 and the thermoelectric energy generation and catalytic conversion devices 150. As with FIG. 4, the chambers 255 shown in FIG. 5 are depicted without fins for simplicity, however, those having skill in the art will appreciate that the chambers 255 may include fins.

As described above, the use of relatively low CTE materials to form the hot and cold source chambers of the thermoelectric energy generation and catalytic conversion devices of the present teachings, such as, for example, a glass ceramic, may permit relatively large substrates (e.g., on the order of 100 mm x 200 mm) to be used without generating too much stress even when subjected to relatively large thermal gradients. The ability to use such a relatively large footprint thermoelectric energy generation and catalytic conversion device may permit a single device to be used and placed across two or more of the cylinders of the engine block, with appropriate flow communication structures to flow the exhaust from the engine into the device. Nevertheless, it may be desirable in some circumstances to utilize one thermoelectric energy generation and catalytic conversion device per cylinder, as shown in the exemplary embodiment of FIG. 5. For example, in some cases the material of the cylinder block 100 (e.g., including aluminum cylinder blocks) presents a CTE that differs too greatly from the relatively low CTE of the thermoelectric generation and catalytic conversion device. Such a thermal mismatch may pose connection challenges and undesirable stress where the thermoelectric energy generation and catalytic conversion devices are joined with the engine block 100. By providing one thermoelectric energy generation and catalytic conversion device 150 per cylinder 120, the CTE mismatch may be managed locally by a flat-to-flat connection between the devices 150 and the cylinder block 100. The flat-to-flat connection may permit the opposing surfaces of the devices 150 and the cylinder block 100 to slip laterally relative to each other during thermal dilatation without losing air tightness and/or causing undesirable stress.

As shown in FIG. 2, in various exemplary embodiments, internal surface portions 258 of the hot source chambers 255 may include fins 260 for increasing the surface area carrying the catalyst and also enhancing thermal exchanges. In various exemplary embodiments, the fins 260 may be arranged on the long sides of the chambers 255; however, those skilled in the art would appreciate that the fins 260 could have numerous arrangements without departing from the scope of the present teachings. The fins 260 may be micro fins molded during the forming of the substrate layers 282 and 284, respectively, exemplary embodiments of which will be described in more detail below.

According to various exemplary embodiments, and with reference to FIG. 6 showing one set of fins on a side of a chamber 255, the height h_{f} of the fins 260 may range from about 100 micrometers (µm) to about 3 mm, for example, the height h_{f} may be about 1 mm. Further, the fins 260 may have a width w_{f} at their base ranging from about 40 µm to about 1 mm, for example, the width w_{f} may be about 0.4 mm. The fins 260 may be tapered, for example, presenting a cone or truncated-cone configuration with a base adjacent the inner surface 258 of the chambers 255. The angle of taper from the base to a free end of the fins may range from about 5° to about 20°, for example, about 15°. The tapered configuration of the fins 260 may enhance heat transfer and also may facilitate removal during the molding process. In various exemplary embodiments, the pitch p between adjacent fins 260 may range from about 0.2 mm to about 5 mm, for example, the pitch p may be about 1 mm pitch.

Those having skill in the art will appreciate that the configuration of the fins, including, for example, their height, width, angle of taper, pitch, and/or positioning, may be altered to achieve, for example, desired surface area, heat exchange and/or catalyst interaction characteristics. As with other internal surface portions of the chambers 255, the fins 260 may carry catalytic particles, including high-temperature catalytic materials, such as, for example, Platinum (Pt), Palladium (Pd), and/or Rhodium (Rh). By way of example, a wash coat deposition technique, with which those having skill in the art are familiar, may be utilized to provide the fins 260, and any other interior surface portions of the hot source chambers, with catalytic particles.

In accordance with various exemplary embodiments, with the exception of the thermoelectric elements and electrodes, the main body portion of thermoelectric energy generation and catalytic conversion devices (e.g., the substrates 282, 284, 292, 294, 296, and 298 shown in the exemplary embodiment of FIG. 2) may be made of a relatively low CTE material, such as, for example, a relatively low CTE glass ceramic material, including but not limited to, for example, the materials described in WO 2008/106099. As described above, materials suitable for forming the main body portion of the thermoelectric energy generation and catalytic conversion devices in accordance with exemplary embodiments of the present teachings may exhibit one or more of the following: chemical resistance to exhaust or other post-combustion waste gases or resistance to oxidation at post-combustion exposure temperatures; a low thermal expansion coefficient (CTE), less than about 30 x 10⁻⁷ °C⁻¹, for example, ranging from about 10 x 10⁻⁷ °C⁻¹ to about 20 x 10⁻⁷ °C⁻¹, at the operating temperatures of interest (from about 20 °C to about 1000 °C); a relatively high thermal conductivity of, for example, above about 2.5 W/m*K in a temperature range of about, for example, 20 °C to about 1000 °C to achieve sufficient thermal conduction on the cold side of the thermoelectric layer, thereby promoting thermal gradient establishment within thermoelectric elements; a relatively large heat capacity for slowing down warming or cooling rates, which may be beneficial either for fast catalytic reaction or light off, and for the fast warming of the thermoelectric elements delivering their maximum efficiency at high temperature; and good heat resistance, for example, about 800 °C permanent and about 950 °C peak so as to be compatible with the temperature of post-combustion exhaust gases.

Exemplary materials that may be used to form the substrates of the thermoelectric energy generation and catalytic conversion devices in accordance with exemplary embodiments of the present teachings include, but are not limited to, cordierite ceramic, cordierite glass ceramic, lithium aluminosilicate glass ceramic, and silicides, such as, for example, silicon nitride ceramic. One exemplary material that may be used to form the substrates of the thermoelectric energy generation and catalytic conversion devices in accordance with exemplary embodiments of the present teaching is cordierite. Cordierite has a relatively low thermal expansion coefficient (CTE) that ranges from about 10 X 10⁻⁷ to about 20 x 10⁻⁷ °C⁻¹ at temperatures ranging from about 100 °C to about 900 °C; a relatively high thermal conductivity ranging from about 1.5 W/m*K to about 4 W/m*K; a relatively large heat capacity ranging from about 0.8 J/g/°C to about 0.9 J/g/°C; and a heat resistance about 1000°C.

The thermoelectric elements of various exemplary embodiments may comprise p- and n-type semiconductor materials, with which those having ordinary skill in art are familiar. Such materials include, for example, Bismuth Telluride. However, Bismuth Telluride typically is used in relatively low temperature applications, for example, on the order of about 150 °C. When used in a post-combustion application, such as, for example, in an automotive application as described herein, it may be desirable to use a material for the thermoelectric elements that is able to withstand relatively high temperatures and high temperature gradients. Further, when used in a consumer application, such as, for example, in an automotive vehicle, it may be desirable to use thermoelectric element materials that do no present toxicity concerns. Additionally, it may be desirable to use thermoelectric element materials that minimize the differential dilatation effects between the main body portion (e.g., glass ceramic substrates) of the thermoelectric energy generation and catalytic conversion device and the thermoelectric elements. Excessive differential dilation can cause undesired mechanical stresses and failure of the device structure.

Thus, suitable materials for thermoelectric elements may exhibit a relatively low CTE ranging, for example, from about 60 x 10⁻⁷ °C⁻¹ to about 100 x 10⁻⁷ °C⁻¹ for temperatures ranging from about 100 °C to about 900 °C, a relatively high heat resistance of about 1 W/m*K (Watts per meters-Kelvin) to about 3 W/mK, and a relatively high dimensionless figure of merit ZT, for example ranging from about 0.6 to about 1.2, for example, from about 1.0 to about 1.5, in a temperature ranging from about 100 °C to about 900 °C.

In various exemplary embodiments, oxide thermoelectric materials may be used, as they may be non-toxic and capable of withstanding high temperatures as their sintering occurs at temperatures ranging from about 1000 °C to about 1300 °C. Examples of such materials include, for example, oxides of manganite, cobaltite, and tin.

Another material exhibiting desirable properties that may be used for the p- and n-type thermoelectric elements in accordance with various exemplary embodiments of the present teachings is doped silicon-germanium alloy, for example, phosphorus doped Si_{0,8}Ge_{0,2}. This alloy has a relatively low CTE ranging from about 40 X10⁻⁷ °C⁻¹ to about 50 X10⁻⁷ °C⁻¹, can operate at high temperatures ranging from about 1000 °C to about 1200 °C, and has a relatively high dimensionless figure of merit, for example, about 0.8 at 1000 °C.

In various exemplary embodiments, the thermoelectric elements may be formed using a hot-forming technique, such as, for example, a hot-pressing or hot-rolling technique according to a process described in international application publication WO 2008/106161, which published on September 4, 2008, and is entitled "METHODS FOR FORMING COMPOSITIONS CONTAINING GLASS,".

In addition to the materials discussed above, those having skill in the art would understand, based on the present teachings, how to select other materials suitable for the thermoelectric elements. Further, WO 2008/106099, discloses other suitable materials for thermoelectric elements that may be used for the exemplary embodiments of the present teachings.

In accordance with various exemplary embodiments, various electrode materials, such as, for example, silver, gold, platinum, palladium, platinum/palladium alloys, and/or silver coated copper or nickel, may be used for the electrodes. Those having skill in the art would be familiar with other suitable electrode materials. In an exemplary embodiment, the electrodes used to connect the thermoelectric elements, for example, electrodes 276 depicted in the exemplary embodiment of FIG. 2, may be in the form of ductile electrodes configured to survive exposure to temperatures of up to about 1000 °C. In various exemplary embodiments, the electrodes may be deposited as a paste (e.g., a silver or gold paste) on the appropriate surface portions of the substrates, for example in the series of cavities formed in the substrate layers 282, 284, 294, and 296 in FIG. 2, and the thermoelectric elements 272, 273 may be implanted in the paste. The implanted thermoelectric elements and paste may be heated to cure the paste to form the electrodes (e.g., electrodes 276 in FIG. 2) and/or bond the thermoelectric elements thereto. Depending on the paste material, the curing may be performed at a temperature ranging from about 650 °C to about 1300 °C for about 1 hour or more. In various exemplary embodiments, the curing may occur after the substrate layers are sealed together.

In accordance with various exemplary embodiments, as discussed above, the thermoelectric energy generation and catalytic conversion devices of the present teachings may have a main body portion that is formed from a plurality of substrate layers (e.g., made of relatively low CTE material, such as a glass ceramic, as discussed above) defining various cavities that, when sealed together, form the various chambers for fluid circulation and for implanting and housing the thermoelectric elements. With reference to FIG. 2, for example, in various exemplary embodiments, two substrate layers 282 and 284 defining cavities on one side thereof may be sealed together such that their respective cavities face one another and together form the hot source chambers 255. On either side of the so-formed hot source chambers 255, the cold source chambers 275 may be formed by two similar substrate layers 292 and 294 forming the bottom cold source chambers in FIG. 2 and substrate layers 296 and 298 forming the top. In addition to defining cavities that face one another to form the hot source chambers 255 and the cold source chambers 275, respectively, each of the substrate layers 282, 284, 292, 294, and 296 each also defines a series of smaller cavities on a surface opposite to the cavities defining the hot source 255 and cold source chambers 275, respectively. The cavities in that series are configured to receive the thermoelectric elements 272 and 273; the thermoelectric elements 272 and 273 being secured between the substrate layers 294 and 282, and 296 and 284, respectively, and bonded thereto via the electrodes 276.

At locations along each substrate 282, 284, 294, and 296 that include cavities on both sides of the substrates, the substrates present a thinner region. Such a thinner region may enhance heat transfer from the chambers 255 or 275 to the thermoelectric elements 272, 273. In various exemplary embodiments, the thinner regions of the substrates 282, 284, 294, and 296 may range from about 0.4 mm to about 0.8 mm, for example, about 0.5 mm, while the overall thickness of the substrates 282, 284, 294, and 296 may range from about 3 mm to about 15 mm.

According to various exemplary embodiments, the substrate layers may be hot formed, for example, by hot-pressing or hot-rolling techniques, as disclosed in WO 2008/106161, . By way of example, formation of the substrate layers forming the cold source chambers may be formed using hot formed molds, such as, for example, graphite molds. A double-sided pressing operation may be useful to form on one side of a substrate layer one or more cavities for forming the hot or cold source chamber and, on the opposite side, one or more cavities for receiving the thermoelectric elements. Reference is made to WO 2008/106161 for a further explanation of such a double-sided hot pressing operation that may be used to form the substrates and corresponding cavities of the substrates of various exemplary embodiments of the present teachings.

To form the glass ceramic substrate layers, after hot-forming takes place, a ceramization cycle is implemented. In accordance with various exemplary embodiments, the individual substrate layers may be sealed to each other by thermal sealing or frit sealing, for example utilizing a softer glass frit material as a sealing medium, in a thermal cycle that occurs during or after a ceramization cycle.

For a further description of exemplary techniques useful for making the thermoelectric energy generation and catalytic conversion devices of the present teachings, reference is made to WO 2008/106099,. Those having skill in the art will appreciate various other techniques that may be used to form the thermoelectric energy generation and catalytic conversion devices of the present teachings and that the exemplary techniques described herein are nonlimiting.

In view of the foregoing, those having ordinary skill in the art will appreciate various desirable features that may be derived from various exemplary embodiments of the integrated thermoelectric energy and catalytic conversion devices in accordance with the present teachings. By way of example, the devices in accordance with exemplary embodiments of the present teachings may save space, reduce cost, promote efficiency, and be environmentally-friendly.

Based on the present teachings, those having skill in the art would understand how to modify the configuration, including material selection, number, configuration, and arrangement of fluid circulation chambers and thermoelectric layers, and operation of an integrated thermoelectric energy generation and catalytic conversion device to achieve desired energy and catalytic conversion, without departing from the scope of the present teachings. Moreover, various modifications may be made to the methods of making the devices described herein without departing from the scope of the present teachings.

For the purposes of this specification and appended claims, unless otherwise indicated, all numbers expressing quantities, percentages or proportions, and other numerical values used in the specification and claims, are to be understood as being modified in all instances by the term "about." Accordingly, unless indicated to the contrary, the numerical parameters set forth in the following specification and attached claims are approximations that may vary depending upon the desired properties sought to be obtained by the present invention. At the very least, and not as an attempt to limit the application of the doctrine of equivalents to the scope of the claims, each numerical parameter should at least be construed in light of the number of reported significant digits and by applying ordinary rounding techniques.

Notwithstanding that the numerical ranges and parameters setting forth the broad scope of the invention are approximations, the numerical values set forth in the specific examples are reported as precisely as possible. Any numerical value, however, inherently contains certain errors necessarily resulting from the standard deviation found in their respective testing measurements. Moreover, all ranges disclosed herein are to be understood to encompass any and all subranges subsumed therein.

It is noted that, as used in this specification and the appended claims, the singular forms "a," "an," and "the," and any singular use of any word, include plural referents unless expressly and unequivocally limited to one referent. As used herein, the term "include" and its grammatical variants are intended to be non-limiting, such that recitation of items in a list is not to the exclusion of other like items that can be substituted or added to the listed items.

It should be understood that while the invention has been described in detail with respect to certain exemplary embodiments thereof, it should not be considered limited to such, as numerous modifications are possible without departing from the broad scope of the appended claims.

## Claims

1. An energy conversion device (150, 350) comprising:
at least one hot source chamber (255, 355) configured to receive a hot fluid, wherein the at least one hot source chamber (255, 355) is configured to perform catalytic conversion of the hot fluid received therein;
at least one cold source chamber (275, 375) configured to receive a coolant; and
a plurality of thermoelectric elements (272, 273, 773) in thermal communication with the at least one hot source chamber (255, 355) and at least one cold source chamber (275, 375), the thermoelectric elements (272, 273, 773) being configured to create an electric potential when exposed to a temperature gradient,
wherein the at least one hot source chamber (255, 355) and the at least one cold source chamber (275, 375) are formed from a material having a relatively low coefficient of thermal expansion of less than 30 x 10⁻⁷ °C⁻¹ at temperatures ranging from 20 °C to 1000 °C.

2. The energy conversion device (150, 350) of claim 1, wherein the at least one hot source chamber (255, 355) and the at least one cold source chamber (275, 375) are formed from a glass ceramic material.

3. The energy conversion device (150, 350) of any of claims 1-2, wherein the material having a relatively low coefficient of thermal expansion is selected from cordierite ceramic, cordierite glass ceramic, lithium aluminosilicate glass ceramic, and silicide materials.

4. The energy conversion device (150, 350) of any of claims 1-3, wherein the at least one hot source chamber (255, 355) comprises a plurality of fins (260).

5. The energy conversion device (150, 350) of any of claims 1-4, wherein the at least one cold source chamber (275, 375) is configured to receive coolant from an automotive vehicle cooling system.

6. The energy conversion device (150, 350) of any of claims 1-5, wherein the at least one hot source chamber (255, 355) is configured to receive exhaust gas from an internal combustion engine.

7. The energy conversion device (150, 350) of any of claims 1-6, further comprising a plurality of substrates (282, 284, 292, 294) comprising a material having a relatively low coefficient of thermal expansion of less than 30 x 10⁻⁷°C⁻¹ at temperatures ranging from 20°C to 1000°C, the substrates defining cavities and being joined together to form the at least one hot source chamber (255, 355) and the at least one cold source chamber (275, 375).

8. The energy conversion device 150, 350) of claim 7, wherein the plurality of thermoelectric elements (272, 273, 773) are disposed between two substrates (282-294, 284-296) and are in thermal contact with the hot source chamber (255, 355) on a first side of the thermoelectric elements and in thermal contact with the cold source chamber (275, 375) on a second opposite side of the thermoelectric elements.

9. The energy conversion device (150, 350) of any one of claims 1-8, wherein it has a substantially planar, layered substrate configuration with central substrate layers (282, 284) forming hot source chambers (255, 355) and outer substrate layers (292, 294, 296, 298) forming cold source chambers (275, 355).

10. The energy conversion device (150, 350) of any of claims 1-9, wherein the thermoelectric elements (272, 273, 773) are made of materials selected from oxides of manganite, cobaltite, and tin.

11. The energy conversion device (150, 350) of any of claims 1-10, wherein the thermoelectric elements (272, 273, 773) are made of doped silicon-germanium alloy.

12. The energy conversion device (150, 350) of claim 11, wherein the thermoelectric elements (272, 273, 773) are made by a hot-pressing or hot-rolling technique.

13. The energy conversion device (150, 350) of any of claims 1-12, wherein the thermoelectric elements (272, 273, 773) comprise p-type and n-type elements.

14. The energy conversion device (150, 350) of any of claims 1-13, further comprising electrodes (276, 776) in electrical contact with the plurality of thermoelectric elements.

15. The energy conversion device (150, 350) of claim 14, wherein the electrodes (276, 776) comprise a curable conductive paste.

16. The energy conversion device (150, 350) of any of claims 1-15, wherein the hot source chamber (255, 355) comprises a washcoat containing a catalyst.

17. The energy conversion device (150, 350) of any of claims 1-16, wherein the hot source chamber (255, 355) comprises a plurality of baffles (410) and inclined walls (415, 420) configured to cause turbulence in the hot fluid flowing through the hot source chamber (255, 355).

18. The energy conversion device (150, 350) of any of claims 1-17, wherein the energy conversion device is configured to be attached to an engine block of an automotive vehicle via a flat-to-flat connection.

19. A method for converting heat to electrical energy, the method comprising:
flowing a hot fluid through at least one hot source chamber (255, 355) formed from a material having a relatively low coefficient of thermal expansion of less than 30 x 10⁻⁷°C⁻¹ at temperatures ranging from 20°C to 1000°C;
performing catalytic conversion of the hot fluid flowing through the hot source chamber;
flowing a coolant through at least one cold source chamber (275, 375) formed from a material having a relatively low coefficient of thermal expansion of less than 30 x 10⁻⁷°C⁻¹ at temperatures ranging from 20°C to
creating a temperature gradient across a plurality of thermoelectric elements (272, 273, 773) via thermal exchange between the plurality of thermoelectric elements and the at least one hot source and at least one cold source chambers; and
generating an electric potential via the plurality of thermoelectric elements.

20. The method of claim 19, wherein the material having a relatively low coefficient of thermal expansion of the at least one hot source chamber (255, 355) and the at least one cold source chamber (275, 375) comprises a glass ceramic material.

21. The method of any of claims 19-20, wherein flowing the hot fluid through the at least one hot source chamber (255, 355) comprises flowing an exhaust gas from an internal combustion engine through the at least one hot source chamber (255, 355).

22. The method of any of claims 19-21, wherein flowing the coolant through the at least one cold source chamber (275, 375) comprises flowing coolant from an automotive vehicle coolant system through the at least one cold source chamber (275, 375).

23. The method of any of claims 19-22, further comprising generating turbulence in a flow of the hot fluid flow during the flowing of the hot fluid through the at least one hot source chamber (255, 355).

## Patentansprüche

1. Energieumwandlungsvorrichtung (150, 350), umfassend:
wenigstens eine Heißquellenkammer (255, 355), die dazu ausgelegt ist, ein heißes Fluid aufzunehmen, wobei die wenigstens eine Heißquellenkammer (255, 355) dazu ausgelegt ist, eine katalytische Umwandlung des darin aufgenommen heißen Fluids durchzuführen,
wenigstens eine Kaltquellenkammer (275, 375), die dazu ausgelegt ist, ein Kühlmittel aufzunehmen, und
mehrere thermoelektrische Elemente (272, 273, 773) in thermischem Austausch mit der wenigstens einen Heißquellenkammer (255, 355) und der wenigstens einen Kaltquellenkammer (275, 375), wobei die thermoelektrischen Elemente (272, 273, 773) dazu ausgelegt sind, ein elektrisches Potential zu erzeugen, wenn sie einem Temperaturgradienten ausgesetzt sind,
wobei die wenigstens eine Heißquellenkammer (255, 355) und die wenigstens eine Kaltquellenkammer (275, 375) aus einem Material gebildet sind, das einen relativ geringen Wärmeausdehnungskoeffizienten von weniger als 30 x 10⁻⁷ °C⁻¹ bei Temperaturen im Bereich von 20 °C bis 1000 °C aufweist.

2. Energieumwandlungsvorrichtung (150, 350) nach Anspruch 1, wobei die wenigstens eine Heißquellenkammer (255, 355) und die wenigstens eine Kaltquellenkammer (275, 375) aus einem Glaskeramikmaterial gebildet sind.

3. Energieumwandlungsvorrichtung (150, 350) nach einem der Ansprüche 1 bis 2, wobei das Material, das einen relativ geringen Wärmeausdehnungskoeffizienten aufweist, aus Cordieritkeramik, Cordieritglaskeramik, Lithiumaluminiumsilicatglaskeramik und Silicidmaterialien ausgewählt ist.

4. Energieumwandlungsvorrichtung (150, 350) nach einem der Ansprüche 1 bis 3, wobei die wenigstens eine Heißquellenkammer (255, 355) mehrere Rippen (260) umfaßt.

5. Energieumwandlungsvorrichtung (255, 355) nach einem der Ansprüche 1 bis 4, wobei die wenigstens eine Kaltquellenkammer (275, 375) dazu ausgelegt ist, ein Kühlmittel von einem Kraftfahrzeugkühlsystem aufzunehmen.

6. Energieumwandlungsvorrichtung (255, 355) nach einem der Ansprüche 1 bis 5, wobei die wenigstens eine Heißquellenkammer (255, 355) dazu ausgelegt ist, Abgas von einem Verbrennungsmotor aufzunehmen.

7. Energieumwandlungsvorrichtung (150, 350) nach einem der Ansprüche 1 bis 6, ferner umfassend mehrere Substrate (282, 284, 292, 294), die ein Material umfassen, das einen relativ geringen Wärmeausdehnungskoeffizienten von weniger als 30 x 10⁻⁷ °C⁻¹ bei Temperaturen im Bereich von 20 °C bis 1000 °C aufweist, wobei die Substrate Hohlräume begrenzen und so zusammengefügt sind, daß sie die wenigstens eine Heißquellenkammer (255, 355) und die wenigstens eine Kaltquellenkammer (275, 375) bilden.

8. Energieumwandlungsvorrichtung (150, 350) nach Anspruch 7, wobei die mehreren thermoelektrischen Elemente (272, 273, 773) zwischen den beiden Substraten (282-294, 284-296) angeordnet sind und in thermischem Austausch mit der Heißquellenkammer (255, 355) auf einer ersten Seite der thermoelektrischen Elemente und in thermischem Austausch mit der Kaltquellenkammer (275, 375) auf einer zweiten gegenüberliegenden Seite der thermoelektrischen Elemente stehen.

9. Energieumwandlungsvorrichtung (150, 350) nach einem der Ansprüche 1 bis 8, wobei sie eine im wesentlichen planare geschichtete Substratkonfiguration mit mittleren Substratschichten (282, 284), die die Heißquellenkammern (255, 355) bilden, und mit äußeren Substratschichten (292, 294, 296, 298), die die Kaltquellenkammern (275, 375) bilden, aufweist.

10. Energieumwandlungsvorrichtung (150, 350) nach einem der Ansprüche 1 bis 9, wobei die thermoelektrischen Elemente (272, 273, 773) aus Materialien hergestellt sind, die aus Oxiden von Manganit, Kobaltit und Zinn ausgewählt sind.

11. Energieumwandlungsvorrichtung (150, 350) nach einem der Ansprüche 1 bis 10, wobei die thermoelektrischen Elemente (272, 273, 773) aus einer dotierten Silicium-Germanium-Legierung hergestellt sind.

12. Energieumwandlungsvorrichtung (150, 350) nach Anspruch 11, wobei die thermoelektrischen Elemente (272, 273, 773) mittels einer Warmpreß- oder Warmwalztechnik hergestellt sind.

13. Energieumwandlungsvorrichtung (150, 350) nach einem der Ansprüche 1 bis 12, wobei die thermoelektrischen Elemente (272, 273, 773) p-leitende und n-leitende Elemente umfassen.

14. Energieumwandlungsvorrichtung (150, 350) nach einem der Ansprüche 1 bis 13, ferner umfassend Elektroden (276, 776) in elektrischem Kontakt mit den mehreren thermoelektrischen Elementen.

15. Energieumwandlungsvorrichtung (150, 350) nach Anspruch 14, wobei die Elektroden (276, 776) eine härtbare Leitpaste umfassen.

16. Energieumwandlungsvorrichtung (150, 350) nach einem der Ansprüche 1 bis 15, wobei die Heißquellenkammer (255, 355) eine einen Katalysator enthaltende Grundierung umfaßt.

17. Energieumwandlungsvorrichtung (150, 350) nach einem der Ansprüche 1 bis 16, wobei die Heißquellenkammer (255, 355) mehrere Trennwände (410) und geneigte Wände (415, 420) umfaßt, die dazu ausgelegt sind, Turbulenzen in dem heißen Fluid, das durch die Heißquellenkammer (255, 355) fließt, hervorzurufen.

18. Energieumwandlungsvorrichtung (150, 350) nach einem der Ansprüche 1 bis 17, wobei die Energieumwandlungsvorrichtung dazu ausgelegt ist, an einem Motorblock eines Kraftfahrzeuges über eine Flach-an-flach-Verbindung befestigt zu sein.

19. Verfahren zum Umwandeln von Wärme in elektrische Energie, wobei das Verfahren umfaßt:
Strömenlassen eines heißen Fluids durch wenigstens eine Heißquellenkammer (255, 355), die aus einem Material gebildet ist, das einen relativ geringen Wärmeausdehnungskoeffizienten von weniger als 30 x 10⁻⁷ °C⁻¹ bei Temperaturen im Bereich von 20 °C bis 1000 °C aufweist,
Durchführen einer katalytischen Umwandlung des heißen Fluids, das durch die Heißquellenkammer fließt,
Strömenlassen eines Kühlmittels durch wenigstens eine Kaltquellenkammer (275, 375), die aus einem Material gebildet ist, das einen relativ geringen Wärmeausdehnungskoeffizienten von weniger als 30 x 10⁻⁷ °C⁻¹ bei Temperaturen im Bereich von 20 °C bis 1000 °C aufweist, und
Erzeugen eines Temperaturgradienten über mehrere thermoelektrische Elemente (272, 273, 773) über thermischen Austausch zwischen den mehreren thermoelektrischen Elementen und der wenigstens einen Heißquellen- und der wenigstens einen Kaltquellenkammer, und
Erzeugen eines elektrischen Potentials über die mehreren thermoelektrischen Elemente.

20. Verfahren nach Anspruch 19, wobei das Material der wenigstens einen Heißquellenkammer (255, 355) und der wenigstens einen Kaltquellenkammer (275, 375), das einen relativ geringen Wärmeausdehnungskoeffizienten aufweist, ein Glaskeramikmaterial umfaßt.

21. Verfahren nach einem der Ansprüche 19 bis 20, wobei Strömenlassen des heißen Fluids durch die wenigstens eine Heißquellenkammer (255, 355) Strömenlassen eines Abgases von einem Verbrennungsmotor durch die wenigstens eine Heißquellenkammer (255, 355) umfaßt.

22. Verfahren nach einem der Ansprüche 19 bis 21, wobei Strömenlassen des Kühlmittels durch die wenigstens eine Kaltquellenkammer (275, 375) Strömenlassen des Kühlmittels von einem Kraftfahrzeugkühlmittelsystem durch die wenigstens eine Kaltquellenkammer (275, 375) umfaßt.

23. Verfahren nach einem der Ansprüche 19 bis 22, ferner umfassend Erzeugen von Turbulenzen in einem Strom des heißen Fluids, während das heiße Fluid durch die wenigstens eine Heißquellenkammer (255, 355) strömt.

## Revendications

1. Dispositif de conversion d'énergie (150, 350) comprenant :
au moins une chambre de source chaude (255, 355) configurée pour recevoir un fluide chaud, où la au moins une chambre de source chaude (255, 355) est configurée pour réaliser une conversion catalytique du fluide chaud reçu à l'intérieur ;
au moins une chambre de source froide (275, 375) configurée pour recevoir un réfrigérant ; et
une pluralité d'éléments thermoélectriques (272, 273, 773) en communication thermique avec la au moins une chambre de source chaude (255, 355) et la au moins une chambre de source froide (275, 375), les éléments thermoélectriques (272, 273, 773) étant configurés pour créer un potentiel électrique quand ils sont exposés à un gradient de température,
où la au moins une chambre de source chaude (255, 355) et la au moins une chambre de source froide (275, 375) sont formées d'un matériau ayant un coefficient de dilatation thermique relativement bas inférieur à 30 x 10⁻⁷°C⁻¹ à des températures allant de 20°C à 1 000°C.

2. Dispositif de conversion d'énergie (150, 350) selon la revendication 1, où la au moins une chambre de source chaude (255, 355) et la au moins une chambre de source froide (275, 375) sont formées d'un matériau vitrocéramique.

3. Dispositif de conversion d'énergie (150, 350) selon l'une quelconque des revendications 1-2, où le matériau ayant un coefficient de dilatation thermique relativement bas est choisi parmi une céramique cordiérite, une vitrocéramique cordiérite, une vitrocéramique d'aluminosilicate de lithium et les matériaux siliciures.

4. Dispositif de conversion d'énergie (150, 350) selon l'une quelconque des revendications 1-3, où la au moins une chambre de source chaude (255, 355) comprend une pluralité d'ailettes (260).

5. Dispositif de conversion d'énergie (150, 350) selon l'une quelconque des revendications 1-4, où la au moins une chambre de source froide (275, 375) est configurée pour recevoir un réfrigérant provenant d'un système de refroidissement de véhicule automobile.

6. Dispositif de conversion d'énergie (150, 350) selon l'une quelconque des revendications 1-5, où la au moins une chambre de source chaude (255, 355) est configurée pour recevoir un gaz d'échappement provenant d'un moteur à combustion interne.

7. Dispositif de conversion d'énergie (150, 350) selon l'une quelconque des revendications 1-6 comprenant en outre une pluralité de substrats (282, 284, 292, 294) comprenant un matériau ayant un coefficient de dilatation thermique relativement bas inférieur à 30 x 10⁻⁷°C⁻¹ à des températures allant de 20°C à 1 000°C, les substrats définissant des cavités et étant joints entre eux pour former la au moins une chambre de source chaude (255, 355) et la au moins une chambre de source froide (275, 375).

8. Dispositif de conversion d'énergie (150, 350) selon la revendication 7, où la pluralité d'éléments thermoélectriques (272, 273, 773) sont disposés entre deux substrats (282-294, 284-296) et sont en contact thermique avec la chambre de source chaude (255, 355) sur un premier côté des éléments thermoélectriques et en contact thermique avec la chambre de source froide (275, 375) sur un second côté opposé des éléments thermoélectriques.

9. Dispositif de conversion d'énergie (150, 350) selon l'une quelconque des revendications 1-8, où il a une configuration de substrats disposés en couches sensiblement plane avec des couches de substrats centrales (282, 284) formant des chambres de source chaude (255, 355) et des couches de substrats externes (292, 294, 296, 298) formant des chambres de source froide (275, 355).

10. Dispositif de conversion d'énergie (150, 350) selon l'une quelconque des revendications 1-9, où les éléments thermoélectriques (272, 273, 773) sont faits de matériaux choisis parmi les oxydes de manganite, cobaltite, et d'étain.

11. Dispositif de conversion d'énergie (150, 350) selon l'une quelconque des revendications 1-10, où les éléments thermoélectriques (272, 273, 773) sont faits d'alliage silicium-germanium dopé.

12. Dispositif de conversion d'énergie (150, 350) selon la revendication 11, où les éléments thermoélectriques (272, 273, 773) sont faits par une technique de compression à chaud ou de laminage à chaud.

13. Dispositif de conversion d'énergie (150, 350) selon l'une quelconque des revendications 1-12, où les éléments thermoélectriques (272, 273, 773) comprennent des éléments de type p et de type n.

14. Dispositif de conversion d'énergie (150, 350) selon l'une quelconque des revendications 1-13, comprenant en outre des électrodes (276, 776) en contact électrique avec la pluralité d'éléments thermoélectriques.

15. Dispositif de conversion d'énergie (150, 350) selon la revendication 14, où les électrodes (276, 776) comprennent une pâte conductrice durcissable.

16. Dispositif de conversion d'énergie (150, 350) selon l'une quelconque des revendications 1-15, où la chambre de source chaude (255, 355) comprend un revêtement contenant un catalyseur.

17. Dispositif de conversion d'énergie (150, 350) selon l'une quelconque des revendications 1-16, où la chambre de source chaude (255, 355) comprend une pluralité de chicanes (410) et des parois inclinées (415, 420) configurées pour provoquer une turbulence dans le fluide chaud s'écoulant à travers la chambre de source chaude (255, 355).

18. Dispositif de conversion d'énergie (150, 350) selon l'une quelconque des revendications 1-17, où le dispositif de conversion d'énergie est configuré pour être fixé à un bloc-moteur d'un véhicule automobile via une liaison à plat.

19. Procédé pour convertir la chaleur en énergie électrique, le procédé comprenant :
l'écoulement d'un fluide chaud à travers au moins une chambre de source chaude (255, 355) formée d'un matériau ayant un coefficient de dilatation thermique relativement bas inférieur à 30 x 10⁻⁷°C⁻¹ à des températures allant de 20°C à 1 000°C ;
la mise en oeuvre d'une conversion catalytique du fluide chaud s'écoulant à travers la chambre de source chaude ;
l'écoulement d'un réfrigérant à travers au moins une chambre de source froide (275, 375) formée d'un matériau ayant un coefficient de dilatation thermique relativement bas inférieur à 30 x 10⁻⁷°C⁻¹ à des températures allant de 20°C à 1 000°C ; et
la création d'un gradient de température de part et d'autre d'une pluralité d'éléments thermoélectriques (272, 273, 773) via échange thermique entre la pluralité d'éléments thermoélectriques et les au moins une chambre de source chaude et au moins une chambre de source froide; et
la formation d'un potentiel électrique via la pluralité d'éléments thermoélectriques.

20. Procédé selon la revendication 19, où le matériau ayant un coefficient de dilatation thermique relativement bas de la au moins une chambre de source chaude (255, 355) et de la au moins une chambre de source froide (275, 375) comprend un matériau vitrocéramique.

21. Procédé selon l'une quelconque des revendications 19-20, où l'écoulement du fluide chaud à travers la au moins une chambre de source chaude (255, 355) comprend l'écoulement d'un gaz d'échappement provenant d'un moteur à combustion interne à travers la au moins une chambre de source chaude (255, 355).

22. Procédé selon l'une quelconque des revendications 19-21, où l'écoulement du réfrigérant à travers la au moins une chambre de source froide (275, 375) comprend l'écoulement d'un réfrigérant provenant d'un système de refroidissement d'un véhicule automobile à travers la au moins une chambre de source froide (275, 375).

23. Procédé selon l'une quelconque des revendications 19-22, comprenant en outre la génération d'une turbulence dans un écoulement du fluide chaud pendant l'écoulement du fluide chaud à travers la au moins une chambre de source chaude (255, 355).
